# EUROPEAN PATENT SPECIFICATION

(11) **EP 0 642 919 B1**
(45) Date of publication and mention of the grant of the patent: **22.10.1997**
(21) Application number: 94110617.1
(22) Date of filing: 07.07.1994
(51) Int. Cl.: B32B 5/26, H05K 1/03, C08J 5/24

(54) **Laminate and multilayer printed circuit board**
Laminat und mehrschichtige leiterplatte
Produit laminé et plaque de circuit imprimé multicouche

(30) Priority: 14.09.1993 JP 228445/93
(43) Date of publication of application: 15.03.1995
(73) Proprietor: HITACHI, LTD., Chiyoda-ku, Tokyo 101 (JP)
(72) Inventor: Nagai, Akira, Hitachi-shi, Iabaraki-ken (JP); Ogata, Masatsugu, Iabaraki-ken (JP)
(74) Representative: Beetz & Partner Patentanwälte

(56) References cited:
- EP-A- 0 412 827
- EP-A- 0 559 437
- EP-A- 0 581 314
- JP-A- 4 356 995
- DATABASE WPI Week 9041, Derwent Publications Ltd., London, GB; AN 90-309588 & JP-A-2 219 853 (MATSUSHITA ELEC WORKS)

## Description

### BACKGROUND OF THE INVENTION

### 1. FIELD OF THE INVENTION

The present invention relates to a laminate and a multilayer printed circuit board on each of which semiconductor elements can be mounted.

### 2. DESCRIPTION OF THE RELATED ART

Multilayer substrates of low thermal expansibilities include a substrate having a ceramics core layer, a substrate with ceramics deposited on a copper foil by flame spraying, and so forth. The coefficients of thermal expansion of these substrates are 10 [ppm/K] or less in the planar directions thereof (in the direction of each substrate within the bonding surface thereof). The ceramics-based substrates, however, are problematic in their drillabilities in the case of forming through-holes. Meanwhile, regarding organic substance based substrates, it has been known that the coefficient of thermal expansion can be reduced by mixing an inorganic filler into a resin system. This contrivance, however, results in enlarging the elastic modulus of the substrate and is not always satisfactory for attaining lower stresses.

It has heretofore been known that a lower elastic modulus can be achieved by adding a rubber type component into the resin component of a laminate material (Japanese Patent Application Laid-open No. 100446/1986). In this case, a flexible substrate of excellent toughness is provided by rendering the resin and rubber type components miscible. This contrivance is really effective to reduce the elastic modulus of the substrate, but it tends to enlarge the thermal expansion coefficient thereof.

It has also been known to apply to a laminate the combination of a matrix resin component and another resin component which exhibits an inferior miscibility with the matrix as represented by a so-called "sea-island structure" (a phase separation structure in which a continuous matrix contains another phase (dispersed islands) existing in an independent state. The island portion is dispersed porion, and the sea portion is contiuous matrix portion).

EP-A-0 581 314 discloses a resin composition of phase separation structure having enhanced fracture resistance. The resin composition comprises a curable dicyanate ester resin having dispersed therein at least one thermoplastic polymer.

JP-A-2219853 dicloses a resin composition having an island structure made of an epoxy resin and a cured elastomer, and a prepreg containing the resin composition. As an elastomer, polyamides or the like are disclosed.

As a further example of such a laminate, there has been proposed a substrate in which a layer made of the resin components of the sea-island structure is formed in only the surface of the substrate, thereby attaining a lower elastic modulus and reducing thermal stresses in the case of packaging semiconductor elements on the laminate (Japanese Patent Application Laid-open No. 356995/1992). With this method, however, it is difficult to reduce the coefficient of thermal expansion of the substrate in the planar direction thereof and it has a slight effect on the characteristics of the whole substrate.

### SUMMARY OF THE INVENTION

The present invention has for its object to provide a laminate, a multilayer printed circuit board and a prepreg each of which exhibits low thermal stresses owing to a small thermal expansion coefficient and a low elastic modulus, and electronics products employing any of them.

In order to accomplish the aforementioned object, the present invention consists in the following expedients:

The first of the expedients is a laminate capable of mounting semiconductor elements thereon; comprising an insulating layer which is constituted by a resin portion of sea-island structure and a woven reinforcement, and which exhibits a coefficient of thermal expansion of 3.0 ∼ 10 [ppm/K] in a planar direction thereof and a glass transition temperature of 150 ∼ 300 [°C].

The second expedient is a multilayer printed circuit board capable of mounting semiconductor elements thereon; comprising at least two insulating layers each of which is constituted by a resin portion of sea-island structure and a woven reinforcement, and each of which exhibits a coefficient of thermal expansion of 3.0 ∼ 10 [ppm/K] in a planar direction thereof and a glass transition temperature of 150 ∼ 300 [°C].

The third expedient is a laminate capable of mounting semiconductor elements thereon; comprising an insulating layer which is constituted by a resin portion of sea-island structure, an inorganic filler and a woven reinforcement, and which exhibits a coefficient of thermal expansion of 3.0 ∼ 10 [ppm/K] in a planar direction thereof and a glass transition temperature of 150 ∼ 300 [°C].

The fourth expedient is a multilayer printed circuit board capable of mounting semiconductor elements thereon; comprising at least two insulating layers each of which is constituted by a resin portion of sea-island structure, an inorganic filler and a woven reinforcement, and each of which exhibits a coefficient of thermal expansion of 3.0 ∼ 10 [ppm/K] in a planar direction thereof and a glass transition temperature of 150 ∼ 300 [°C].

The fifth expedient is a prepreg wherein a woven reinforcement is impregnated with a resin component; comprising the fact that said resin component includes a resin portion of sea-island structure, and that the prepreg after having been set exhibits a coefficient of thermal expansion of 3.0 ∼ 10 [ppm/K] in a planar direction thereof and a glass transition temperature of 150 ∼ 300 [°C].

The sixth expedient is a prepreg wherein a woven reinforcement is impregnated with a resin component; comprising the fact that said resin component includes a resin portion of sea-island structure and an inorganic filler at an average grain diameter of 0.1 ∼ 15 [µm], and that the prepreg after having been set exhibits a coefficient of thermal expansion of 3.0 ∼ 10 [ppm/K] in a planar direction thereof and a glass transition temperature of 150 ∼ 300 [°C].

The seventh expedient is a memory card wherein a memory element is mounted on a circuit board by surface packaging; comprising the fact that said circuit board includes an insulating layer which is constituted by a resin portion of sea-island structure and a woven reinforcement, and which exhibits a coefficient of thermal expansion of 3.0 ∼ 10 [ppm/K] in a planar direction thereof and a glass transition temperature of 150 ∼ 300 [°C].

The eighth expedient is a computer which has a multilayer printed circuit board capable of mounting semiconductor elements thereon; comprising the fact that said multilayer printed circuit board includes an insulating layer which is constituted by a resin portion of sea-island structure and a woven reinforcement, and which exhibits a coefficient of thermal expansion of 3.0 ∼ 10 [ppm/K] in a planar direction thereof and a glass transition temperature of 150 ∼ 300 [°C], and that a signal transmission delay time of said computer is 1 ∼ 15 [ns/m].

The ninth expedient is a communication equipment which has a circuit board capable of mounting semiconductor elements thereon; comprising the fact that said circuit board includes an insulating layer which is constituted by a resin portion of sea-island structure and a woven reinforcement, and which exhibits a coefficient of thermal expansion of 3.0 ∼ 10 [ppm/K] in a planar direction thereof and a glass transition temperature of 150 ∼ 300 [°C], and that a weight of said communication equipment is 10 [g] ∼ 30 [kg].

The tenth expedient is an electronics equipment which has a circuit board capable of mounting semiconductor elements thereon; comprising the fact that said circuit board includes an insulating layer which is constituted by a resin portion of sea-island structure and a woven reinforcement, and which exhibits a coefficient of thermal expansion of 3.0 ∼ 10 [ppm/K] in a planar direction thereof and a glass transition temperature of 150 ∼ 300 [°C], and that a total volume occupied by said semiconductor elements and said circuit board is 1 ∼ 50 [%] with respect to a volume of the whole electronics equipment.

The eleventh expedient is a laminate wherein at least one prepreg or sheet which is constituted by a resin and a woven reinforcement is stacked and bonded; comprising the fact that said woven reinforcement is constructed so as to exhibit an anisotropy as a physical property, and that said resin is in the form of a continuous layer which has a sea-island structure and which prevents the layers of woven reinforcement from coming into contact with each other.

The twelfth expedient is a laminate wherein at least one prepreg or sheet which is constituted by a resin and a woven reinforcement is stacked and bonded; comprising the fact that said woven reinforcement is constructed so as to exhibit an anisotropy as a physical property, that said resin is in the form of a continuous layer which has a sea-island structure and which prevents the layers of woven reinforcement from coming into contact with each other, and that said laminate exhibits a coefficient of thermal expansion of 3.0 ∼ 10 [ppm/K] in a planar direction thereof and a glass transition temperature of 150 ∼ 300 [°C].

In the present invention, a "semiconductor element" is an element in which an IC (integrated circuit) or LSI (large-scale integrated circuit) including, for example, a memory, a logic circuit, a custom IC or/and a power transistor is formed on a wafer made of a semiconductor such as Si (silicon) or GaAs (gallium arsenide), and which has terminals for connecting the IC or LSI to leads, bumps etc. The elements shall include, not only bare chips, but also packaged chips in the state in which the element is covered or encapsulated with a resin or ceramics, in the state in which the element has been subjected to tape automatic bonding (TAB), and so forth.

Also in the present invention, a "laminate" is a structural product or member which is fabricated in such a way that at least one piece of prepreg, sheet or the like which has been obtained by impregnating a woven reinforcement with a resin component is layered, and that the layer is pressed, bonded and molded. By way of example, the woven reinforcements include a piece of cloth or sheet which is made of inorganic type fiber glass of (such as E glass (electrical glass), S glass (structural glass), D glass (dielectric glass) or Q glass (quartz glass)), titanium or the like; a piece of cloth or sheet which is made of organic type fiber of polyamide, polyamidoimide, polyimide, a liquid-crystalline polymer, aromatic polyamide or the like; a piece of cloth which is made of carbon fiber; and a piece of cloth or sheet which is made of at least two kinds of fiber selected from among the inorganic type fiber, organic type fibers and carbon fibers mentioned above. Besides, for such a purpose of enhancing an electromagnetic-wave shielding property, a radiation resistance or a mechanical strength or bestowing an electric conductivity, it is possible to use a piece of cloth or sheet which is made of metal fiber or a piece of cloth or sheet which is made of a composite system consisting of metal fiber and at least one kind of fiber selected from among inorganic type fiber, organic type fiber and carbon fiber.

Also in the present invention, a "multilayer printed circuit board" is a wired circuit board for mounting semiconductor elements thereon, which is formed with at least two wiring layers that are connected by means of through-holes etc. Examples of the wiring layers bear circuits which are formed from foils of metals or by plating with or vacuum evaporation of metals. The metals are copper, silver, gold, aluminum, chromium, molybdenum, tungsten, etc. Especially, copper is preferable, and the copper foil is recommended.

Further, a resinous varnish for impregnating the woven reinforcement in the present invention accounts for about 30 ∼ 90 [weight-%] in terms of the solid matter content of the varnish with respect to the total weight of both the varnish and the woven reinforcement (that is, the woven reinforcement accounts for about 70 ∼ 10 [weight-%] with respect to the total weight). When the proportion of the varnish is smaller, a good prepreg or film is difficult to obtain. On the other hand, when the proportion of the varnish is larger, it is difficult to make the coefficient of thermal expansion of the laminate in the planar direction thereof fall within a range of 3.0 ∼ 10 [ppm/K]. Besides, the effect of reinforcing the laminate decreases.

The laminate according to the present invention is well suited to wiring uses such as, for example, a flexible wiring circuit board and an insulating film to intervene between circuits. By way of example, the flexible wiring circuit board is manufactured as stated below.

First, a piece of glass cloth is impregnated with a varnish which has been prepared by dissolving a resin composite in an organic solvent. Subsequently, while the solvent is vaporized in a drying oven, a setting reaction is somewhat advanced to form a prepreg at B-stage (in the semi-set state in which the prepreg melts when heat is applied thereto). At the next step, metal foils such as copper foils or aluminum foils are superposed on both the surfaces of the prepreg so as to sandwich the prepreg therebetween. Alternatively, such a metal foil is superposed on only one surface of the prepreg. In this state, each metal foil is bonded by thermocompression, and the impregnating resin composite is set at the same time. Next, the surface of the metal foil (copper foil) is coated with resist ink in the shape of a circuit, and the resist ink is dried. Next, the parts of the copper foil except the circuit are etched with, e. g., an aqueous solution of ferric chloride. Subsequently, using an organic solvent such as methylene chloride, the resist ink is removed, and the resulting structure is washed. Lastly, the resulting structure is dipped into a soldering bath so as to stick solder to pertinent parts. Then, the circuit is finished.

For such intended uses, the flexible substrate or flexible circuit board of the present invention is generally put on the market in the semi-set state (as the prepreg) or in the set state after the thermocompression bonding of the metal foil or foils. The flexible substrate or circuit board in the present invention shall include articles in both the semi-set state and the set state.

Incidentally, the multilayer printed circuit board according to the present invention can also be fabricated as stated below. A printed-wiring circuit board already formed with a circuit is coated with a piece of glass cloth which is impregnated with a varnish prepared by dissolving a resin component in a solvent. Subsequently, while the solvent is vaporized in a drying oven, the varnish is somewhat set into the B-stage (into the semi-set state). Thereafter, a metal foil such as copper foil or aluminum foil is superposed on the outer surface of the semi-set resin component, and thermocompression is carried out to bond the metal foil and set the resin component. Further, another circuit is formed by the necessary steps of the method explained above.

In the present invention, the impregnation of a woven reinforcement with a resin can be effected in such a way that a resin solution (varnish) is applied to the woven reinforcement once or a plurality of times by the use of a conventional impregnating-and-coating machine of horizontal type or/and vertical type. Alternatively, the impregnating process can be performed by coating one surface or both surfaces of the woven reinforcement with the resin. Further, the impregnating process can be performed in such a way that a solid resin sheet is superposed on the woven reinforcement beforehand, and that the resulting woven reinforcement is heated and/or molded. If a prepreg or the impregnating sheet after having been dried is tacky, a mold releasing sheet can be used voluntarily at a suitable step. Usable as the mold releasing sheet is cellulosic paper or film coated with a mold releasing agent, polypropylene film, polyvinyl alcohol film, or the like.

In the present invention, a "resin portion of sea-island structure" is made from a resin composite which consists of at least two kinds of substances (e. g., a resin and a compound, or resins) being inferiorly miscible to each other, or from a resin composite which contains a resin of phase separation type, such as a polymer produced by copolymerizing components of inferior miscibility. In the resin composite, one component should desirably have a lower elastic modulus than the other component or components. The resin composite to be selected and used is a composite which has the sea-island structure and in which at least one of components conjointly employed is immiscible with the other component or components.

Mentioned as the resins of the resin composites are various thermosetting resins, for example, an epoxy resin, an unsaturated polyester resin, an epoxy - isocyanate resin, a maleimide resin, a maleimide - epoxy resin, a cyanate ester resin, a cyanate ester - epoxy resin, a cyanate ester - maleimide resin, a phenolic resin, a diallylphthalate resin, an urethane resin, a cyanamide resin and a maleimide - cyanamide resin.

By way of example, silicon-containing compounds, fluorine-containing compounds, and the polymers of these compounds are mentioned as the compounds and resins which are immiscible with the aforementioned thermosetting resins and which form the sea-island structures when mixed with these thermosetting resins. Typical examples of the silicon-containing compounds are organosiloxane and organopolysiloxane each of which has at its terminals or its side chains, functional groups such as amino groups, carboxyl groups, epoxy groups, hydroxyl groups, pyrimidinyl groups or carboxylic groups. Typical examples of the fluorine-containing compounds are polyperfluoroethers, PTFE (polytetrafluoroethylene), PFA (tetrafluoroethylene perfluoroalkyl vinyl ether copolymer), FEP (tetrafluoroethylene hexafluoropropene copolymer), PCTFE (polychlorotrifluoroethylene), ETFE (ethylene tetrafluoroethylene copolymer), ECTFE (ethylene chlorotrifluoroethylene copolymer), PVDF (polyvinylidene difluoride) and PVF (polyvinyl fluoride) each of which has at its terminals or its side chains, functional groups such as amino groups, carboxyl groups, epoxy groups, hydroxyl groups, pyrimidinyl groups, isocyanic groups or carboxylic groups. Each of the polymers of the specified compounds should preferably have a molecular weight of 10³ ∼ 10⁶. Such a polymer is effective to lower the elastic modulus.

In the present invention, the aforementioned resin composites of high heat resistances are especially favorable in order that the insulating layer of a laminate or a multilayer printed circuit board, a prepreg, etc. may exhibit glass transition temperatures falling within a range of 150 ∼ 300 [°C] (the reasons for the specified range will be explained below). Besides, in the present invention, the aspect of the immiscibility may be either of a nonreactive type or a reactive type, but the reactive type is favorable from the viewpoint of bestowing the high heat resistances. By way of example, in the case of a resin composite which consists of an epoxy compound and a silicon-containing compound, the silicon-containing compound and the epoxy compound which have groups being reactive with epoxy groups or hydroxyl groups can be previously reacted in a solution at the preparation of a varnish. On this occasion, it is also possible to add a setting agent, an inorganic filler and/or a coupling agent.

In the present invention, the glass transition temperature of the insulating layer should preferably fall within the range of 150 ∼ 300 [°C]. In the case of a glass transition temperature below 150 [°C], it becomes difficult to satisfactorily clear the reliability tests (for example, a high-temperature shelf test and a heat cycle test) of the product such as the laminate or the multilayer printed circuit board. On the other hand, in the case of a glass transition temperature above 300 [°C], the bestowal of the flexibility is difficult, so that the problems of cracking and inferior molding characteristics are involved in the product.

Further, in the present invention, the "coefficient of thermal expansion in a planar direction" signifies the coefficient of thermal expansion within a bonding surface in a laminate. More specifically, there are three sorts of thermal expansion coefficients within the bonding surface of the laminate. The direction in which a tension acts on a woven reinforcement at the step of coating in the manufacture of a prepreg, is assumed an X-direction. In addition, the direction which is orthogonal to the X-direction is assumed to be a Y-direction. Besides, the direction which is 45 [degrees] slant to the X- and Y-directions is assumed to be a bias direction. In general, the magnitudes of the coefficients of thermal expansion are in the order of the bias direction > the Y-direction > the X-direction. In the bias direction which is 45 [degrees] slant, the woven reinforcement and the step of stacking and bonding the prepreg exert the least influences. In the present invention, therefore, the coefficient of thermal expansion in the bias direction shall be representatively stipulated as the coefficient of thermal expansion in the planar direction.

Still further, in the present invention, the coefficient of thermal expansion in the planar direction should preferably fall within a range of 3.0 ∼ 10 [ppm/K]. The coefficient of thermal expansion of a semiconductor element (for example, made from silicon) is 3.0 ∼ 4.0 [ppm/K]. Also, the coefficient of thermal expansion of an encapsulating resin in a resin-molded semiconductor device is, only slightly greater than the value of silicon. In order to enhance the reliability of the connections between the semiconductor element and a laminate (or a multilayer printed circuit board), it is effective to reduce thermal stresses which arise between both the members or articles. To this end, the difference between the thermal expansion coefficients of the laminate and the semiconductor element can be rendered small in such a way that the coefficient of thermal expansion of the laminate (or the multilayer printed circuit board) in the planar direction thereof is brought into the range of 3.0 ∼ 10 [ppm/K]. Moreover, since the construction of the multilayer printed circuit board according to the present invention does not include ceramics as its constituent, it can lower the coefficient of thermal expansion. Accordingly, the following effects are brought forth:
(1) The multilayer printed circuit board exhibits a superior drillability.
(2) The connection reliability of through-holes in the multilayer printed circuit board is high owing to the superior close adhesion of the circuit board with a plated metal.
(3) The multilayer printed circuit board can be made lighter in weight.
(4) Since a lower elastic modulus can be attained simultaneously with the lower coefficient of thermal expansion, a large number of electrical parts having different thermal expansion coefficients can be mounted on the identical surface of the multilayer printed circuit board. The differences of the thermal expansion coefficients can be covered or hidden by the lower elastic modulus.
(5) A substrate or circuit board of large area can be manufactured by the same techniques as in the prior art.

According to the present invention, various electrical parts such as semiconductor elements can be mounted by surface packaging by employing a circuit board which is constituted by a resin portion and a woven reinforcement, the resin portion having a sea-island structure and exhibiting a coefficient of thermal expansion of 3.0 ∼ 10 [ppm/K] in a planar direction thereof, as well as a glass transition temperature of 150 ∼ 300 [°C]. Thus, the circuit board is superior in drillability to a ceramics-containing substrate which is a prior-art substrate of low thermal expansion for the surface packaging, and it is very effective for the reliability of through-holes because the close adhesion thereof with a plated metal is more intense than that of ceramics. In general, a ceramics-based circuit board is less bondable with a resin, and it therefore poses a problem with regard to the reliability of the interface between the circuit board and the resin.

In contrast, such an interface of different phases does not exist in the circuit board according to the present invention. It is accordingly possible to provide a memory card of high reliability. Moreover, the circuit board according to the present invention does not contain ceramics, and the sea-island structure of its resin portion results in a lower elastic modulus compared with an unmodified state. Therefore, even when various electrical parts having unequal thermal expansion coefficients are to be mounted together on the circuit board, thermal stresses which arise at a mounting step are of small magnitude. It is accordingly possible to provide a multifunctional memory card of superior connection reliability.

Besides, the thermal expansion coefficient of a thin package for semiconductor elements of high integration density is nearly equal to that of silicon and is 6 [ppm/K] or so. The semiconductor elements of high integration density having low thermal expansion coefficients are therefore permitted to be mounted densely by surface packaging while the connection reliability is kept high, by employing a circuit board which is constituted by a resin portion and a woven reinforcement, the resin portion having a sea-island structure and exhibiting a coefficient of thermal expansion of 3.0 ∼ 10 [ppm/K] in a planar direction thereof, as well as a glass transition temperature of 150 ∼ 300 [°C]. Thus, signal transmission distances can be shortened, and a computer of high arithmetic processing speed in which signal transmission delay times are 1 ∼ 15 [ns/m] can be provided. Moreover, since a reduced size and a lightened weight are attained by the dense packaging, a computer of superior portability can be provided.

According to the present invention, a reduced size and a lightened weight of 10 [g] ∼ 30 [kg] can be attained to provide a communication equipment of superior portability in such a way that electrical parts such as semiconductor elements are mounted at a high integration density by surface packaging, by employing a circuit board which is constituted by a resin portion and a woven reinforcement, the resin portion having a sea-island structure and exhibiting a coefficient of thermal expansion of 3.0 ∼ 10 [ppm/K] in a planar direction thereof, as well as a glass transition temperature of 150 ∼ 300 [°C]. Typical examples of the communication equipment are a portable telephone set and a portable radio equipment. Further, the sea-island substrate is lighter in weight than a ceramics-containing substrate. Still further, compared with the elastic modulus of the ceramics-containing substrate or an unmodified substrate, that of the sea-island substrate is lowered considerably. Therefore, even when various electrical parts having unequal thermal expansion coefficients are to be mounted together on the circuit board, thermal stresses which arise at a mounting step are of small magnitude, and a communication equipment of superior connection reliability can be provided. Accordingly, multifarious communication equipments can be fabricated in accordance with purposes.

According to the present invention, it is possible to provide a car electronics equipment including electrical parts such as semiconductor elements, which equipment can reduce the occupying volume of its packaging portion (concretely, a total volume to be occupied by the semiconductor elements and a circuit board can be made 1 ∼ 50 [%] with respect to the volume of the whole electronics equipment) and can endure a high-temperature and high-humidity environment such as an engine room, in such a way that the electrical parts such as semiconductor elements are mounted at a high integration density by surface packaging, by employing the circuit board which is constituted by a resin portion and a woven reinforcement, the resin portion having a sea-island structure and exhibiting a coefficient of thermal expansion of 3.0 ∼ 10 [ppm/K] in a planar direction thereof, as well as a glass transition temperature of 150 ∼ 300 [°C]. Typical examples of such a car electronics equipment are an engine control device and a navigation device. It is necessary for these devices to be installed in limited places having severe environmental conditions. To this end, the equipment which employs the circuit board constituted by the resin portion of the sea-island structure can achieve a reduced size by the dense packaging. Moreover, since the circuit board does not contain any ceramics material, it has few interfaces of different phases and exhibits a superior connection reliability. Accordingly, the circuit board is well suited for use in the field of car electronics.

In operation, in a laminate which has a resin and a reinforcement, the present invention puts the components of a resin composite into a sea-island structure, namely, a phase separation structure, whereby the thermal expansion coefficient and elastic modulus of the resin composite can be simultaneously reduced. As an example of a mechanism far the manifestation of the phase separation structure, in a case where the phase separation resin of the resin composite has an island structure of low elastic modulus, the resin of the resin composite as a matrix layer will have its elastic modulus reduced owing to a moldability added by the island parts of the island structure. Regarding the coefficient of thermal expansion of the resin composite in the planar direction of the laminate, it is considered that the thermal expansion of the matrix resin will crush the island parts, with the result that the thermal expansion of the whole resin composite will decrease apparently. Other phase separation structures can simultaneously reduce both the characteristics through various manifestative mechanisms.

Not all of the manifestative mechanisms have yet been satisfactorily made clear.

### BRIEF DESCRIPTION OF THE DRAWINGS

Fig. 1 is a model diagram showing the section of a laminate according to the present invention;
Fig. 2 is a model diagram showing the section of a laminate in the prior art; and
Fig. 3 is a model diagram showing the section of another laminate in the prior art.

### PREFERRED EMBODIMENTS OF THE INVENTION

Now, the present invention will be described in detail in conjunction with examples.

### (Example 1)

88 parts [by weight] of phenol novolac resin (trade name "XL225-3L", produced by Mitsui Toatsu Chamicals, Inc.) as a setting agent and 10 parts [by weight] of amine-modified dimethylsiloxane ("PS513", Chisso Corporation) as a component of low elastic modulus were added to 100 parts [by weight] of epoxy compound ("EXA-1514", Dainippon Ink and Chamicals, Inc.) in methyl ethyl ketone. Thus, a varnish which had a solid matter content of 50 [weight-%] was prepared. A piece of E-glass (electrical glass) cloth 100 [µm] thick was impregnated and coated with the varnish, and then dried at 120 [°C] for 10 [min] so as to remove the solvent. Thus, a piece of prepreg was obtained. The resin content of the obtained prepreg was 70 [weight-%].

Copper foils (each being 18 [µm] thick) were respectively superposed on both the surfaces of the obtained prepreg, and the resulting structure was pressed under heat by a press. Thus, a laminate was obtained. As pressing conditions on this occasion, two-stage reactions at 130 [°C] for 30 [min] and at 180 [°C] for 60 [min] were performed, and a pressure of 196.2 N/cm² (20 [kg/cm²]) was held. The copper foil peeling strength of the obtained laminate, and the thermal expansion coefficient of the laminate in the planar direction thereof after having etched the copper foils were evaluated by the TMA (Thermal Mechanical Analyzer) method. Besides, in order to measure the elastic modulus of the resin portion of the laminate, resin powder was scratched off the prepreg, and a resin sheet was fabricated from the resin powder under the same pressing conditions as those of the laminate. The sample of the resin sheet had its elastic modulus at room temperature evaluated by a viscoelastic measurement.

### (Example 2)

Resin components were prescribed in such a way that 55 parts [by weight] of phenol novolac (trade name "H100", produced by Hitachi Chamical Co., Ltd.) as a setting agent and 15 parts [by weight] of epoxy-modified polydimethylsiloxane ("SF8413", Toray Silicon Kabushiki-Kaisha) as a component of low elastic modulus were added to 100 parts [by weight] of epoxy compound ("YX4000H", Yuka Shell Kabushiki-Kaisha). On this occasion, the setting agent and the component of low elastic modulus were reacted at 90 [°C] for 30 [min] in methyl isobutyl ketone beforehand as a pre-reaction, and the resulting solution was cooled down to room temperature. Thereafter, the epoxy compound was added into the cooled solution. Thus, a varnish which had a solid matter content of 50 [weight-%] was prepared. A piece of S-glass (structural glass) cloth 70 [µm] thick was impregnated and coated with the prepared varnish, and then dried at 140 [°C] for 10 [min] so as to remove the solvent. Thus, a piece of prepreg was obtained.

A laminate and a resin sheet were fabricated from the obtained prepreg by the same methods as in Example 1, and their characteristics were similarly estimated.

### (Example 3)

Resin components were prescribed as consisting of 100 parts [by weight] of maleimide compound (bis(4-maleimidophenyl) methane, produced by Mitsui Toatsu Chamicals, Inc.), 38 parts [by weight] of amine compound (2, 2-bis(4-(4-aminophenoxy) phenyl) propane, Wakayama Seika Kabushiki-Kaisha) and 5 parts [by weight] of amine-modified polydimethylsiloxane (trade name "SF8418", Toray Silicon Kabushiki-Kaisha). On this occasion, pre-reactions were so performed that 50 parts [by weight] of the maleimide compound and the amine-modified polydimethylsiloxane were reacted in dimethylformamide at 110 [°C] for 20 [min], and that the remaining 50 parts [by weight] of the maleimide compound and the amine compound were added into the resulting solution and were reacted for 20 [min]. Thus, a varnish which had a solid matter content of 40 [weight-%] was prepared. Further, 20 parts [by weight] of fused silica filler (at an average grain diameter of 10 [µm]) were mixed and dispersed into the prepared varnish. A piece of D-glass (dielectric glass) cloth 80 [µm] thick was impregnated and coated with the resulting varnish, and then dried at 140 [°C] for 5 [min] and at 145 [°C] for 5 [min] so as to remove the solvent. Thus, a piece of prepreg was obtained.

A laminate was fabricated from the obtained prepreg by a method similar to that in Example 1, and its characteristics were similarly estimated. The molding conditions of the laminate were 130 [°C] for 30 [min] and 200 [°C] for 60 [min].

### (Example 4)

Resin components were prescribed in such a way that 72 parts [by weight] of orthocresol novolac (trade name "OCN7000", produced by Nihon Kayaku Kabushiki-Kaisha) as a setting agent and 10 parts [by weight] of both-terminal carboxylic acid-modified perfluoroether ("ZDIAC-2000", Monte Ferrous Inc.) as a component of low elastic modulus were added to 100 parts [by weight] of epoxy compound ("YX4000H", Yuka Shell Kabushiki-Kaisha). On this occasion, 1 part [by weight] of imidazole ("2E4MZ", Shikoku Kasei Kabushiki-Kaisha) was added as a setting accelerator. Using acetone as a solvent, a varnish which had a solid matter content of 60 [weight-%] was prepared. A piece of polyamide cloth 70 [µm] thick was impregnated and coated with the prepared varnish, and then had the solvent removed by drying stages at 110 [°C] for 10 [min] and at 120 [°C] for 15 [min]. Thus, a piece of prepreg was obtained.

A laminate was fabricated from the obtained prepreg by a method similar to that in Example 1, and its characteristics were similarly estimated. The molding conditions of the laminate were 130 [°C] for 30 [min] and 200 [°C] for 60 [min].

### (Comparative Example 1)

A laminate and a resin sheet, each of which included a homogeneous resin portion having no sea-island structure, were fabricated using the materials of Example 1 except polydimethylsiloxane, that is, using the epoxy compound and the phenolic setting agent. The characteristics of the laminate and the resin sheet were estimated.

### (Comparative Example 2)

A laminate and a resin sheet, each of which included a homogeneous resin portion having no sea-island structure, were fabricated using the materials of Example 3 except polydimethylsiloxane, that is, using the maleimide compound, the amine compound and the fused silica filler. The characteristics of the laminate and the resin sheet were estimated.

Further, element packages in the number of 100 were soldered by surface packaging onto each of printed-wiring circuit boards in each of which a predetermined circuit was formed on the laminate covered with the copper foils as explained in Example 1 (in other words, the element packages were mounted on both the surfaces of each of the printed-wiring circuit boards by soldering). The soldering was carried out by heating-reflow which utilized a far-infrared heater. Each of the samples of packaged articles was tested for 100 cycles in conformity with the MIL (military specification and standards), and the number of defects of soldered connection parts after the end of the test was counted. The measured characteristics of the above examples including the number of the defective soldered connection parts are listed in Table 1 below:

**TABLE 1**

| | Coeff. of In-plane thermal expansion [× 10⁶/K] | Elastic modulus [GPa] ([kg·f/mm²]) | Glass transition temperature [°C] | Number of Defective parts (in 100 parts) |
|---|---|---|---|---|
| Example 1 | 9.2 | 2.89 (295) | 156 | 0 |
| Example 2 | 8.7 | 2.75 (280) | 175 | 0 |
| Example 3 | 7.2 | 2.94 (300) | 285 | 0 |
| Example 4 | 6.5 | 3.14 (320) | 173 | 0 |
| Comp. Ex. 1 | 12.5 | 3.63 (370) | 155 | 11 |
| Comp. Ex. 2 | 11.5 | 4.41 (450) | 285 | 17 |

### (Example 5)

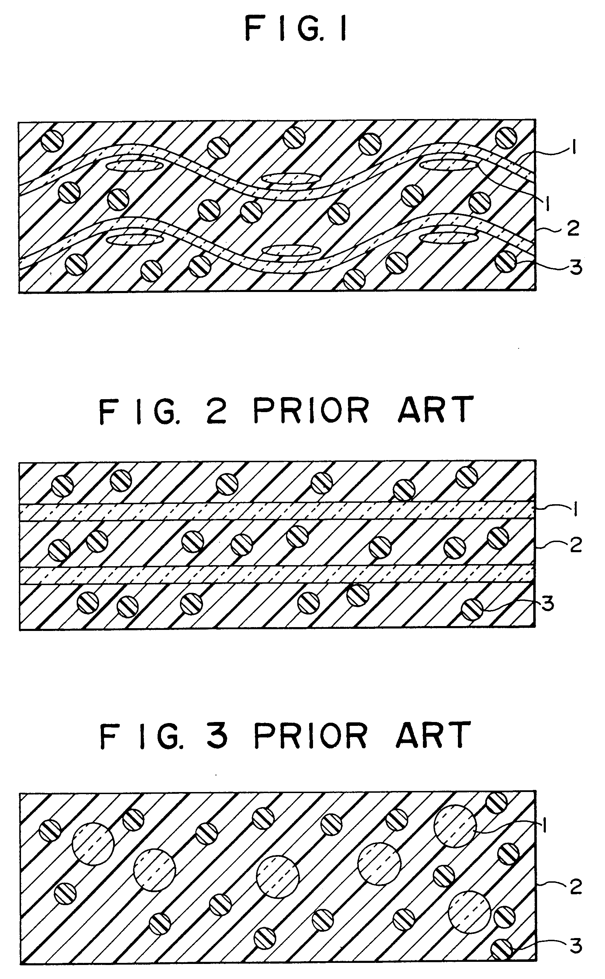

Fig. 1 illustrates the construction of a laminate according to the present invention.

The laminate can be fabricated by stacking and bonding two pieces of prepreg each of which is obtained in such a way that a woven reinforcement 1 is impregnated with a resin portion 2 having a sea-island structure and is then dried. In the construction, the woven reinforcement 1 exists entirely in the planar direction of the laminate. Therefore, the effect of reducing the thermal expansion coefficient of the laminate in the planar direction thereof can be utilized to the utmost on the basis of the sea-island structure. Incidentally, numeral 3 in Fig. 1 designates a dispersed (island) phase.

Since an organic resin matrix constituting the resin portion 2 of the sea-island structure is continuously existent penetrating the reinforcement members 1, the laminate is free from the problem of bonding at the interface between different phases in a composite material.

### (Comparative Example 3)

Fig. 2 illustrates a construction of a laminate in the prior art.

The construction is very effective in reducing the thermal expansion coefficient of the laminate in the planar direction thereof. In this construction, however, a resin matrix which constitutes a resin portion 2 of sea-island structure including islands 3 does not continuously penetrate reinforcement members 1. Therefore, the laminate is liable to pose the problem of bonding at the interface between different phases, and so forth.

### (Comparative Example 4)

Fig. 3 illustrates a construction of a laminate in the prior art.

In the construction, a woven reinforcement 1 exists in the form of independent particles, so that the whole laminate exhibits an isotropy. It is therefore impossible to make the most of the effect of reducing the thermal expansion coefficient of the laminate, in the planar direction thereof. Herein, the effect is based on the interaction between a resin matrix and islands 3 which form a resin portion 2 of sea-island structure.

### (Examples 6 ∼ 8)

88 parts [by weight] of phenol novolac resin (trade name "XL225-3L", produced by Mitsui Toatsu Chamicals, Inc.) as a setting agent, and 10 parts, 20 parts and 50 parts [by weight] of amino-group-terminal perfluoroether type compound (produced by Mitsui Fluorochemical Kabushiki-Kaisha) as a component of low elastic modulus were respectively added to 100 parts [by weight] of epoxy compound ("EXA-1514", Dainippon Ink and Chamicals, Inc.) in methyl ethyl ketone. Thus, three kinds of varnish each of which had a solid matter content of 50 [weight-%] were prepared. Pieces of E-glass (electrical glass) cloth each being 100 [µm] thick were respectively impregnated and coated with the varnish samples, and then dried at 120 [°C] for 10 [min] so as to remove the solvent. Thus, pieces of prepreg were obtained. The resin content of each of the obtained prepreg pieces was 70 [weight-%].

Copper foils (each being 18 [µm] thick) were respectively superposed on both the surfaces of each of the obtained prepreg pieces, and the resulting structures were respectively pressed under heat by a press. Thus, laminates were obtained. As pressing conditions on this occasion, two-stage reactions at 130 [°C] for 30 [min] and at 180 [°C] for 60 [min] were performed, and a pressure of 196.2 N/cm² (20 [kg/cm²])was held. The copper foil peeling strengths of the obtained laminates, and the thermal expansion coefficients of the laminates in the planar directions thereof after having etched the copper foils were respectively evaluated by the TMA (Thermal Mechanical Analyzer) method. Besides, in order to measure the elastic moduli of the resin portions of the laminates, powdery resins were respectively scratched off the corresponding prepreg pieces, and resin sheets were respectively fabricated from the powdery resins under the same pressing conditions as those of the laminates. The samples of the resin sheets had their elastic moduli at room temperature evaluated by viscoelastic measurements, respectively.

### (Example 9)

Resin components were prescribed in such a way that 55 parts [by weight] of phenol novolac (trade name "H100", produced by Hitachi Chamical Co., Ltd.) as a setting agent and 15 parts [by weight] of carboxyl-group-terminal perfluoroether type compound (produced by Mitsui Fluorochemical Kabushiki-Kaisha) as a component of low elastic modulus were added to 100 parts [by weight] of epoxy compound ("YX4000H", Yuka Shell Kabushiki-Kaisha). On this occasion, the setting agent and the component of low elastic modulus were reacted at 90 [°C] for 30 [min] in methyl isobutyl ketone beforehand as a pre-reaction, and the resulting solution was cooled down to a room temperature. Thereafter, the epoxy compound was added into the cooled solution. Thus, a varnish which had a solid matter content of 50 [weight-%] was prepared. A piece of S-glass (structural glass) cloth 70 [µm] thick was impregnated and coated with the prepared varnish, and then dried at 140 [°C] for 10 [min] so as to remove the solvent. Thus, a piece of prepreg was obtained.

A laminate and a resin sheet were fabricated from the obtained prepreg by the same methods as in Examples 6 ∼ 8, and their characteristics were similarly estimated.

Likewise to Examples 1 thru 4 and Comparative Examples 1 and 2, packaged articles were fabricated for Examples 6 thru 9, and the samples thereof were tested as to the defects of soldered connection parts.

The measured characteristics of Examples 6 thru 9 are listed in Table 2 below:

**TABLE 2**

| | Coeff. of In-plane thermal expansion [× 10⁶/K] | Elastic modulus [GPa] ([kg·f/mm²]) | Glass transition temperature [°C] | Number of Defective parts (in 100 parts) |
|---|---|---|---|---|
| Example 6 | 8.7 | 2.91 (297) | 188 | 0 |
| Example 7 | 8.5 | 2.90 (290) | 195 | 0 |
| Example 8 | 7.6 | 2.80 (280) | 197 | 0 |
| Example 9 | 8.0 | 2.82 (282) | 202 | 0 |

According to the present invention, the coefficients of thermal expansion of a laminate, a multilayer printed circuit board and a prepreg in the planar directions thereof are reduced along with the elastic moduli thereof, thereby making it possible to remarkably lower thermal stresses which arise on packaging surfaces and to sharply enhance the reliabilities of the connections of the laminate etc. with articles or elements which are to be packaged.

## Claims

1. A prepreg wherein a woven reinforcement (1) is impregnated with a resin composite, which comprises
a resin portion (2) having a phase separation structure and including a continuous matrix of a resin and a dispersed phase (3) of another compound or resin dispersed in the matrix,
characterized in that
(A) the dispersed phase (3) is at least one member selected from
(A1) silicon-containing compounds and polymers thereof and
(A2) fluorine-containing compounds and polymers thereof, selected from polyperfluoroethers, PTFE (polytetrafluoroethylene), PFA (tetrafluoroethylene-perfluoroalkyl-vinylether copolymers), FEP (tetrafluoroethylene-hexafluoropropene copolymers), PCTFE (polychlorotrifluoroethylene), ETFE (ethylene-tetrafluoroethylene copolymers), ECTFE (ethylene-chlorotrifluoroethylene copolymers), PVDF (polyvinylidenedifluoride) and PVF (polyvinylfluoride),
each of (A1) and (A2) having at its terminals or its side chains, functional groups such as amino groups, carboxy groups, epoxy groups, hydroxy groups, pyrimidinyl groups or isocyanic groups,
(B) the coefficient of thermal expansion in a direction forming an angle of 45 degrees with respect to the direction of a tension given to the woven reinforcement during the manufacturing of the prepreg is 3.0 - 10 ppm/K in a plane including the bonding surface of the prepreg after the prepreg has been set,
and
(C) the glass transition temperature of the resin composite after having been set is 150-300 °C.

2. The prepreg according to claim 1, wherein the resin composite further includes an inorganic filler having an average grain diameter of 0.1 - 15 µm.

3. The prepreg according to claim 1 and/or 2, wherein the continuous matrix is an epoxy resin, an unsaturated polyester resin, an epoxy-isocyanate resin, a maleimide resin, a maleimide-epoxy resin, a phenolic resin, a diallylphthalate resin, an urethane resin, a cyanamide resin and a maleimide-cyanamide resin.

4. Laminates for mounting semiconductor elements thereon, comprising one or more insulating layers obtained by setting one or more prepregs according to any of claims 1 to 3.

5. The laminate according to claim 4, wherein at least one prepreg is in the form of a sheet.

6. The laminate acccording to claim 4 and/or 5, wherein at least one prepreg according to any of claims 1 to 3 is stacked and bonded, the woven reinforcement (1) being constructed so as to exhibit an anisotropy as a physical property, and the resin portion (2) is in the form of a continuous layer and prevents the layers of the woven reinforcement (1) from coming into contact with each other.

7. Multilayer printed circuit boards for surface mounting semiconductor elements thereon, comprising
at least two insulating layers, each obtained by setting the prepreg according to any of claims 1 to 3.

8. Memory cards, comprising a memory element provided on a circuit board by surface mounting, wherein the circuit board includes an insulating layer obtained by setting the prepreg according to any of claims 1 to 3,
a laminate according to any of claims 4 to 6 or is a multilayer circuit board according to claim 7.

9. Computers, communication equipment and electronics equipment including printed circuit boards having surface mounted semiconductor elements thereon and which include an insulating layer obtained by setting the prepreg according to any of claims 1 to 3, a laminate according to any of claims 4 to 6, or which are multilayer circuit boards according to claim 7.

10. The electronics equipment according to claim 9, wherein the electronics equipment is one for use in an automobile.

11. The electronics equipment according to claim 9, wherein the electronics equipment is an audio equipment.

## Patentansprüche

1. Prepreg, bei dem eine gewebte Verstärkung (1) mit einem Compositharz imprägniert ist, das einen Harzanteil (2) aufweist, der eine Phasentrennungsstruktur besitzt und eine kontinuierliche Matrix aus einem Harz und eine dispergierte Phase (3) aus einer anderen Verbindung oder einem anderen Harz, die in der Matrix dispergiert ist, aufweist,
dadurch gekennzeichnet, daß
(A) die dispergierte Phase (3) mindestens ein Material ist, das ausgewählt ist unter
(A1) siliciumhaltigen Verbindungen und Polymeren davon
und
(A2) fluorhaltigen Verbindungen und Polymeren davon, die ausgewählt sind unter Polyperfluorethern, PTFE (Polytetrafluorethylen), PFA (Tetrafluorethylen-Perfluoralkylvinylether-Copolymeren), FEP (Tetrafluorethylen-Hexafluorpropen-Copolymeren), PCTFE (Polychlortrifluorethylen), ETFE (Ethylen-Tetrafluorethylen-Copolymeren), ECTFE (Ethylen-Chlortrifluorethylen-Copolymeren), PVDF (Polyvinylidendifluorid) und PVF (Polyvinylfluorid),
wobei (A1) sowie (A2) an den Kettenenden oder an Seitenketten funktionelle Gruppen, wie Aminogruppen, Carboxygruppen, Epoxygruppen, Hydroxygruppen, Pyrimidinylgruppen oder Isocyangruppen, aufweisen,
(B) der thermische Ausdehnungskoeffizient in einer Richtung, die einen Winkel von 45° mit der Richtung einer Spannung bildet, mit der die gewebte Verstärkung während der Erzeugung des Prepregs beaufschlagt wurde, in einer Ebene, in der die Verbindungsfläche des Prepregs liegt, nach seiner Härtung 3,0 bis 10 ppm/K beträgt
und
(C) die Glasübergangstemperatur des Compositharzes nach der Härtung 150 bis 300 °C beträgt.

2. Prepreg nach Anspruch 1, wobei das Compositharz ferner einen anorganischen Füllstoff mit einer mittleren Korngröße von 0,1 bis 15 µm enthält.

3. Prepreg nach Anspruch 1 und/oder 2, wobei die kontinuierliche Matrix ein Epoxyharz, ein ungesättigtes Polyesterharz, ein Epoxy-Isocyanat-Harz, ein Maleinimidharz, ein Malenimid-Epoxy-Harz, ein Phenolharz, ein Diallylphthalatharz, ein Urethanharz, ein Cyanamidharz oder ein Maleinimid-Cyanamid-Harz ist.

4. Laminate zur Montage von Halbleiterelementen darauf, die eine oder mehrere Isolierschichten aufweisen, die durch Härtung eines oder mehrerer Prepregs nach einem der Ansprüche 1 bis 3 erhalten sind.

5. Laminat nach Anspruch 4, bei dem mindestens ein Prepreg in Form eines Flachmaterials vorliegt.

6. Laminat nach Anspruch 4 und/oder 5, bei dem mindestens ein Prepreg nach einem der Ansprüche 1 bis 3 eine Lage bildet und gebunden ist, wobei die gewebte Verstärkung (1) so aufgebaut ist, daß sie als eine physikalische Eigenschaft Anisotropie aufweist, und der Harzanteil (2) in Form einer kontinuierlichen Schicht vorliegt und verhindert, daß die Schichten der gewebten Verstärkung (1) miteinander in Kontakt kommen können.

7. Gedruckte Mehrschicht-Leiterplatten zur Oberflächenmontage von Halbleiterelementen darauf, die mindestens zwei Isolierschichten aufweisen, die jeweils durch Härten des Prepregs nach einem der Ansprüche 1 bis 3 erhalten sind.

8. Speicherkarten, die mindestens ein Speicherelement aufweisen, das durch Oberflächenmontage auf einer Leiterplatte vorgesehen ist, wobei die Leiterplatte eine Isolierschicht, die durch Härten des Prepregs nach einem der Ansprüche 1 bis 3 erhalten ist, oder ein Laminat nach einem der Ansprüche 4 bis 6 aufweist oder eine Mehrschicht-Leiterplatte nach Anspruch 7 ist.

9. Computer, Kommunikationseinrichtungen und elektronische Einrichtungen, die gedruckte Leiterplatten aufweisen, auf deren Oberfläche Halbleiterelemente montiert sind und die eine Isolierschicht, die durch Härten des Prepregs nach einem der Ansprüche 1 bis 3 erhalten ist, oder ein Laminat nach einem der Ansprüche 4 bis 6 aufweisen oder Mehrschicht-Leiterplatten nach Anspruch 7 sind.

10. Elektronische Einrichtungen nach Anspruch 9, die zum Einsatz in Kraftfahrzeugen vorgesehen sind.

11. Elektronische Einrichtungen nach Anspruch 9, die zum Einsatz in Audiogeräten vorgesehen sind.

## Revendications

1. Préimprégné dans lequel une armature tissée (1) est imprégnée par une résine composite, qui comprend
une partie en résine (2) ayant une structure à séparation de phases et comportant une matrice continue d'une résine et une phase dispersée (3) d'un autre composé ou d'une autre résine dispersée dans la matrice,
caractérisé en ce que
(A) la phase dispersée (3) est au moins un élément choisi parmi
(A1) des composés contenant du silicium, et des polymères de ceux-ci, et
(A2) des composés contenant du fluor, et des polymères de ceux-ci, choisis parmi les polyperfluroéthers, le PTFE (polytétrafluoréthylène), les PFA (copolymères de tétrafluoréthylène-perfluoroalkyl-vinyléther), les FEP (copolymères de tétrafluoréthylène-hexafluoropropène), le PCTFE (polychlorotrifluoréthylène), les ETFE (copolymères d'éthylène-tétrafluoréthylène), les ECTFE (copolymères d'éthylènechlorotrifluoréthylène), le PVDF (polyvinylidène difluorure) et le PVF (polyvinylfluorure),
chacun parmi (A1) et (A2) ayant dans ses chaînes terminales ou latérales des groupes fonctionnels tels que des groupes amino, des groupes carboxy, des groupes époxy, des groupes hydroxy, des groupes pyrimidinyles ou des groupes isocyaniques,
(B) le coefficient de dilatation thermique dans une direction formant un angle de 45 degrés par rapport à la direction d'une tension communiquée à l'armature tissée pendant la fabrication du préimprégné est de 3,0 à 10 ppm/K dans un plan contenant la surface de collage du préimprégné après durcissement du préimprégné,
et
(C) la température de transition vitreuse de la résine composite après durcissement est de 150 à 300°C.

2. Préimprégné selon la revendication 1, dans lequel la résine composite comprend en outre une charge inorganique ayant d'un diamètre moyen des grains de 0,1 à 15 µm.

3. Préimprégné selon la revendication 1 et/ou 2, dans lequel la matrice continue est une résine époxy, une résine de polyester insaturé, une résine époxy-isocyanate, une résine maléimide, une résine maléimide-époxy, une résine phénolique, une résine diallylphtalate, une résine uréthanne, une résine cyanamide et une résine maléimide-cyanamide.

4. Stratifié destiné au montage d'éléments de semi-conducteur, comprenant une ou plusieurs couches isolantes réalisées par durcissement d'un ou plusieurs préimprégnés selon l'une quelconque des revendications 1 à 3.

5. Stratifié selon la revendication 4, dans lequel au moins un préimprégné se présente sous la forme d'une feuille.

6. Stratifié selon la revendication 4 et/ou 5, dans lequel au moins un préimprégné selon l'une quelconque des revendications 1 à 3 est empilé et collé,, l'armature tissée (1) étant confectionnée de façon à présenter une anisotropie en tant que propriété physique, et la partie de résine (2) se présente sous la forme d'une couche continue et empêche les couches de l'armature tissée (1) de venir au contact les unes des autres.

7. Cartes pour circuits imprimés multicouches servant au montage en surface d'éléments semi-conducteurs, comprenant
au moins deux couches isolantes, chacune obtenue en faisant durcir le préimprégné selon l'une quelconque des revendications 1 à 3.

8. Cartes à mémoire, comprenant un élément de mémoire fixé par assemblage en surface sur une carte à circuit imprimé, la carte à circuit comportant une couche isolante réalisée par durcissement du préimprégné selon l'une quelconque des revendications 1 à 3, un stratifié selon l'une quelconque des revendications 4 à 6 ou est une carte à circuit multicouches selon la revendication 7.

9. Ordinateurs, équipements de communication et équipements électroniques comportant des cartes à circuits imprimés comportant des éléments semi-conducteurs fixés en surface et qui comportent une couche isolante réalisée par durcissement du préimprégné selon l'une quelconque des revendications 1 à 3, du laminé selon l'une quelconque des revendications 4 à 6 ou qui sont des cartes à circuits multicouches selon la revendication 7.

10. Equipements électroniques selon la revendication 9, lesdits équipements électroniques étant destinés à être utilisés dans une automobile.

11. Equipements électroniques selon la revendication 9, lesdits équipements électroniques étant des équipements audio.
